Europäisches Patentamt

(19) European Patent Office

Office européen des brevets

(11) Numéro de publication: **0 024 223**
**B1**

(12) **FASCICULE DE BREVET EUROPEEN**

(45) Date de publication du fascicule du brevet:
01.02.84

(51) Int. Cl.³: **H 04 N 3/16**

(21) Numéro de dépôt: **80401086.6**

(22) Date de dépôt: **22.07.80**

(54) Circuit de précorrection du signal de balayage vertical d'un tube de visualisation, et récepteur de télévision comportant un tel circuit.

(30) Priorité: **10.08.79 FR 7920522**

(43) Date de publication de la demande:
**25.02.81 Bulletin 81/8**

(45) Mention de la délivrance du brevet:
**01.02.84 Bulletin 84/5**

(84) Etats contractants désignés:
**DE GB IT NL**

(56) Documents cités:
**DE - B - 2 751 174**
**FR - A - 2 327 689**
**US - A - 3 746 922**

(73) Titulaire: **THOMSON-CSF, 173, Boulevard Haussmann,**
**F-75379 Paris Cedex 08 (FR)**

(72) Inventeur: **van den Driessche, Michel,**
**"THOMSON-CSF" SCPI 173, Bld Haussmann,**
**F-75360 Paris Cedex 08 (FR)**

(74) Mandataire: **de Beaumont, Michel et al, THOMSON-CSF**
**SCPI 173, Bld Haussmann, F-75379 Paris Cedex 08 (FR)**

# Circuit de précorrection du signal de balayage vertical d'un tube de visualisation, et récepteur de télévision comportant un tel circuit

La présente invention concerne un dispositif de précorrection du courant de déviation dans le circuit de balayage vertical d'un tube de visualisation, dans des matériels du type récepteur de télévision ou console de visualisation.

La précorrection, sur le signal de commande, du courant de balayage vertical est généralement désignée par l'expression »correction en S«.

Avec certains types d'ensembles tube de visualisation et déviateur associé, notamment les ensembles de conception ancienne, et particulièrement les tubes noir et blanc, il est nécessaire d'effectuer cette précorrection pour tenir compte, d'une part, de la sphéricité de la partie écran du tube, et pour corriger d'autre part, la déviation du faisceau de particules, déviation qui n'est pas proportionnelle à l'intensité du courant.

Le taux de correction qu'il est nécessaire d'apporter au courant de balayage est essentiellement variable avec le type de tube de visualisation utilisé, et peut varier entre 2% et 30%.

Le dispositif de correction en S selon l'invention est destiné à l'intégration monolithique, et a été étudié pour ne pas subir de dérives dûes au vieillissement ou à l'échauffement des composants qui sont couramment utilisés dans ce cas, c'est-à-dire les condensateurs ou les diodes.

En effet, le circuit de correction en S réalisé ne comporte aucun composant externe tel que condensateur ou diodes: il fonctionne avec un montage utilisant des composants intégrés sur un cristal semiconducteur. Ce montage module le signal de commande monotone en dents de scie par un signal non monotone, la somme des deux signaux étant un signal en S.

De façon plus précise, l'invention réside en un circuit de précorrection du signal de balayage vertical d'un tube de visualisation, le balayage étant piloté par un oscillateur synchronisé par des impulsions ($V_a$) extérieures, lequel fournit un signal ($V_b$) en dents de scie, ce circuit de précorrection étant caractérisé en ce qu'il comporte:
- un circuit d'inversion de polarité commuté qui reçoit sur sa borne d'entrée le signal en dents de scie ($V_b$) et restitue sur sa borne de sortie un signal triangulaire ($I_e$), obtenu par inversion de polarité d'une fraction de la dent de scie, par rapport à une tension de référence ($V_{ref}$) comprise entre les deux tensions de crête de la dent de scie; (valeur moyenne du signal);
- un circuit électronique qui reçoit sur sa borne d'entrée le signal en dent de scie ($V_b$) issu de l'oscillateur et sur sa borne de commande le signal triangulaire ($I_e$) issu du circuit d'inversion de polarité, ce circuit électronique délivrant sur ses bornes de sortie deux courants ($I_1$ et $I_2$) en dents de scie, de même sens, l'un des courants étant affecté d'une correction en S dans un sens et l'autre courant étant affecté de la même correction mais de sens opposé;
- un circuit soustracteur, qui reçoit sur ses deux bornes d'entrée les deux courants ($I_1$ et $I_2$) issus du circuit électronique et restitue sur sa borne de sortie le signal ($V_S$) de précorrection par élimination de la composante en dents de scie.

Ce circuit de correction en S est normalment associé, dans un circuit intégré monolithique, à la fonction complète du balayage vertical.

L'invention sera expliquée par la description d'un exemple de réalisation qui s'appuie sur des figures, lesquelles représentent:

- figure 1: un circuit de précorrection selon l'art connu;
- figure 2: les diagrammes de formes d'onde du circuit précédent;
- figure 3: un second circuit de précorrection selon l'art connu;
- figure 4: le schéma fonctionnel du circuit de précorrection selon l'invention;
- figure 5: les diagrammes de formes d'onde du circuit selon l'invention;
- figure 6: le schéma électrique du circuit d'inversion de polarité commuté;
- figure 7: le schéma électrique du circuit de précorrection selon l'invention;
- figure 8: un premier exemple d'application de la précorrection d'un signal de balayage vertical;
- figure 9: un second exemple d'application.

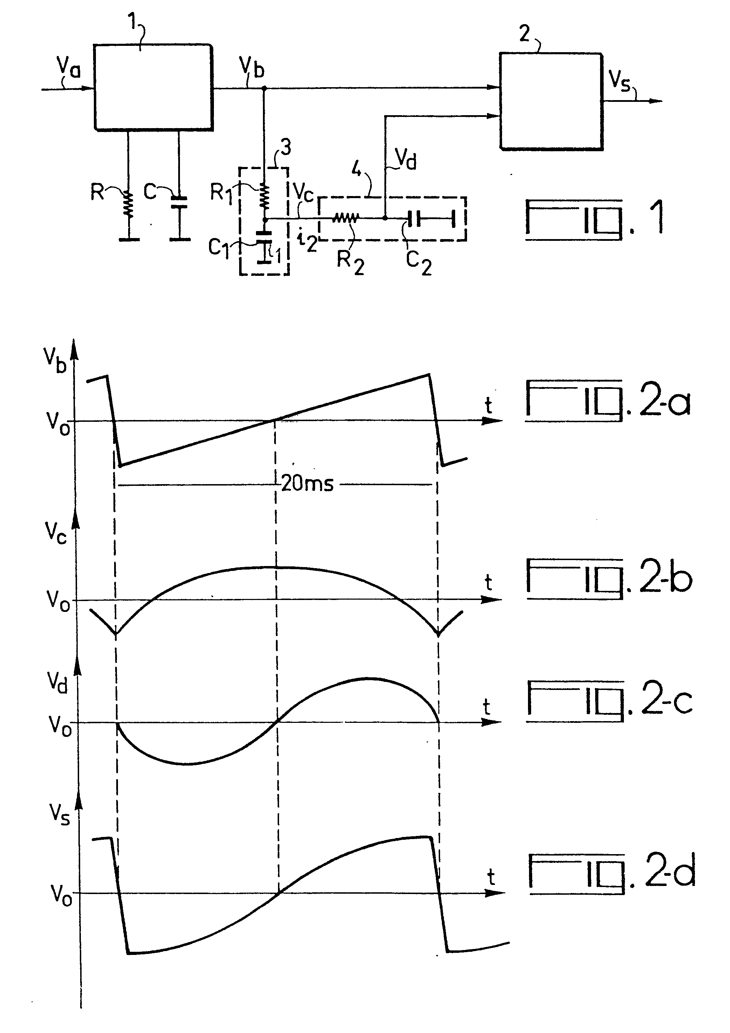

La figure 1 représente le schéma fonctionnel d'un circuit de précorrection selon l'art connu, utilisant deux réseaux intégrateurs.

Un circuit oscillateur 1, synchronisé sur son entrée par une impulsion $V_a$ portée par le signal vidéo-composite, émet un signal $V_b$ en dents de scie dont la période est réglée par une résistance et une capacité. Le signal $V_b$ est adressé directement sur une première borne d'entrée d'un sommateur 2, et indirectement sur une deuxième borne d'entrée du même sommateur à travers deux réseaux intégrateurs 3 et 4. Chaque réseau est constitué par une résistance et une capacité, et le signal est extrait de l'intégrateur entre résistance et capacité: soit $V_c$ le signal extrait du premier intégrateur 3 et $V_d$ le signal extrait du second intégrateur 4, qui est adressé au sommateur 2 dont le signal de sortie est $V_S$.

Le fonctionnement de ce circuit de précorrection sera éclairé par les diagrammes des figures 2 qui ont tous le temps en abscisses.

La figure 2a représente le signal $V_b$ en dents de scie, issu de l'oscillateur 1. Sa période est de 20 ms, et sa valeur moyenne $V_0$.

La figure 2b représente le signal $V_c$ issu du premier intégrateur 3. Si $i_1$ est le courant qui entre dans l'intégrateur, dont la constante de temps $R_1C_1$ est très supérieure à 20 ms, le signal $V_c$ a une forme parabolique régie par l'équation, à l'instant t:

$$V_c(t) = \frac{1}{C_1} \int_0^T i_1(t)\, dt + V_o.$$

La figure 2c représente le signal $V_d$ issu du second intégrateur 4. Pour un courant $i_2$ qui entre dans l'intégrateur, dont la constante de temps $R_2C_2$ est également très supérieure à 20 ms, le signal $V_d$, à l'instant t, est régi par l'équation:

$$V_c(t) = \frac{1}{C_2} \int_0^T i_2(t)\, dt + V_o$$

et a une forme en S.

La figure 2d représente le signal $V_S$ à la sortie du sommateur 2: c'est une dent de scie modulée par le signal en S qui lui est additionnée dans le sommateur:

$$V_S = V_b + V_d$$

Ce système de précorrection en S a principalement deux inconvénients:
- il nécessite au moins deux capacités dont la valeur importante interdit leur intégration sur un cristal, et, par voie de conséquence, celle des deux intégrateurs 3 et 4;
- les dispersions des valeurs des capacités entraînent une variation, d'un appareil au suivant, du taux de précorrection en S, ce qui oblige donc, d'une part, à prévoir des moyens de réglage, d'autre part, à effectuer des réglages en fabrication.

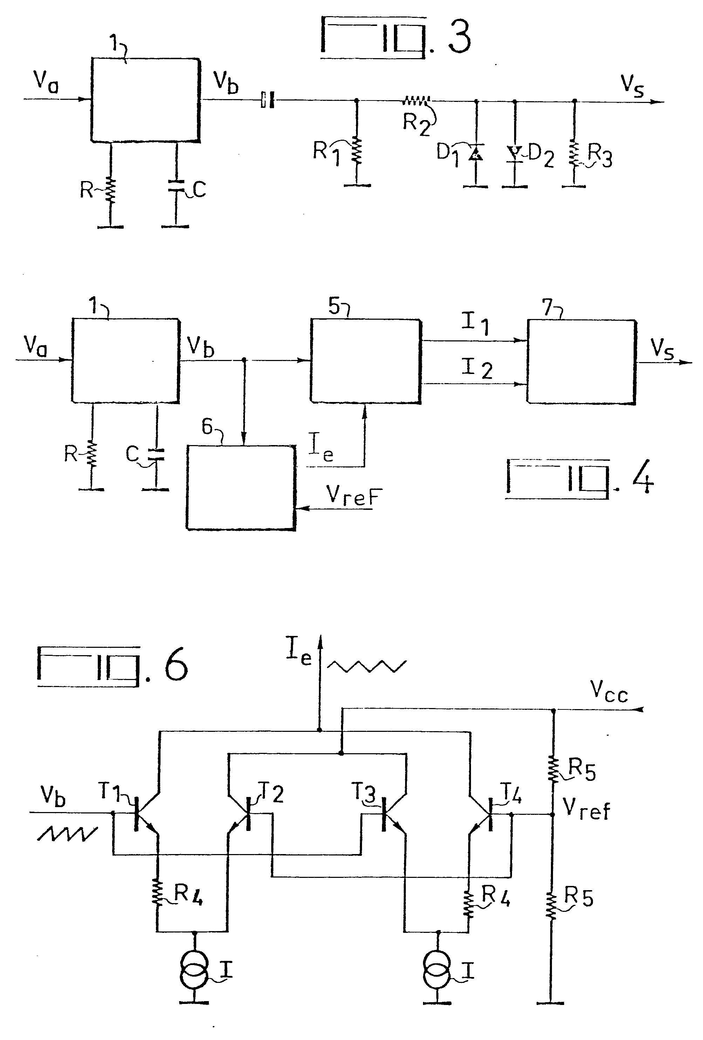

La figure 3 illustre un autre type de circuit de précorrection en S, utilisant des diodes.

Un oscillateur 1, synchronisé sur sa borne d'entrée par un signal $V_a$, délivre sur sa borne de sortie un signal $V_b$ en dents de scie, dont la période est contrôlée par une résistance et une capacité. Le circuit de précorrection, après une capacité de liaison, comprend notamment deux résistances $R_2$ et $R_3$, et deux diodes $D_1$ et $D_2$, montées tête bêche et réunies à la masse électrique.

Ce sont les caractéristiques des diodes qui introduisent une non-linéarité dans le signal $V_b$ en dents de scie. En effet, la caractéristique tension/courant d'une diode est:

$$I = I_o\, e^{V\frac{q}{kT}}$$

dans laquelle q et k sont des constantes, et T la température de la diode. Cela donne:

$$V = \frac{kT}{q} \log \frac{I}{I_o}.$$

Dans la partie négative de la dent de scie, la diode $D_2$ corrige la dent de scie à partir du moment où son seuil de tension est atteint. Dans la partie positive du signal, c'est la diode $D_1$ qui corrige jusqu'au moment où son seuil de tension est atteint.

Le rapport des résistances $R_2$ et $R_3$ et la valeur de la tension en dent de scie déterminent le taux de correction.

Un inconvénient de ce système est qu'une variation des caractéristiques des diodes, liée à une éventuelle variation de température, entraîne une dérive thermique du taux de précorrection, comme le montrent les formules ci-dessus. Ce circuit n'est donc pas directement intégrable car, en circuit intégré, la puce semiconductrice est soumise à des variations de température importantes et la dérive serait inacceptable.

Le circuit selon l'invention répond à une conception qui le rend intégrable sur un cristal semidonducteur, sans autres composants extérieurs que la résistance et la capacité de l'oscillateur. Le signal de précorrection y est généré par un montage de transistors: la suppression des capacités ou des diodes externes supprime également les problèmes d'apairage ou de dérive thermique.

La figure 4 donne le schéma fonctionnel du circuit de précorrection selon l'invention. Le détail en sera donné dans les figures suivantes, mais le fonctionnement en est le suivant: le signal $V_b$ en dents de scie, issu d'un oscillateur 1, est adressé directement sur une première entrée d'un circuit électronique 5, et indirectement sur une seconde entrée de ce circuit 5, à travers un circuit d'inversion de polarité commuté 6. Ce circuit d'inversion 6 reçoit le signal en dents de scie $V_b$, et restitue un signal triangulaire $I_e$ c'est-à-dire composé d'un segment décroissant et d'un segment croissant. Le signal $I_e$ sert de signal de commande pour le circuit 5. Le bloc fonctionnel 7 représente un circuit soustracteur recevant les deux sorties $I_1$ et $I_2$ du circuit 5 et dont le signal de sortie $V_S$ est le signal de précorrection pur, par soustraction du signal en dents de scie $V_b$.

Le circuit soustracteur 7 permet d'affecter un quelconque signal en dents de scie d'un taux de précorrection en S qui est variable selon le type de tube image utilisé.

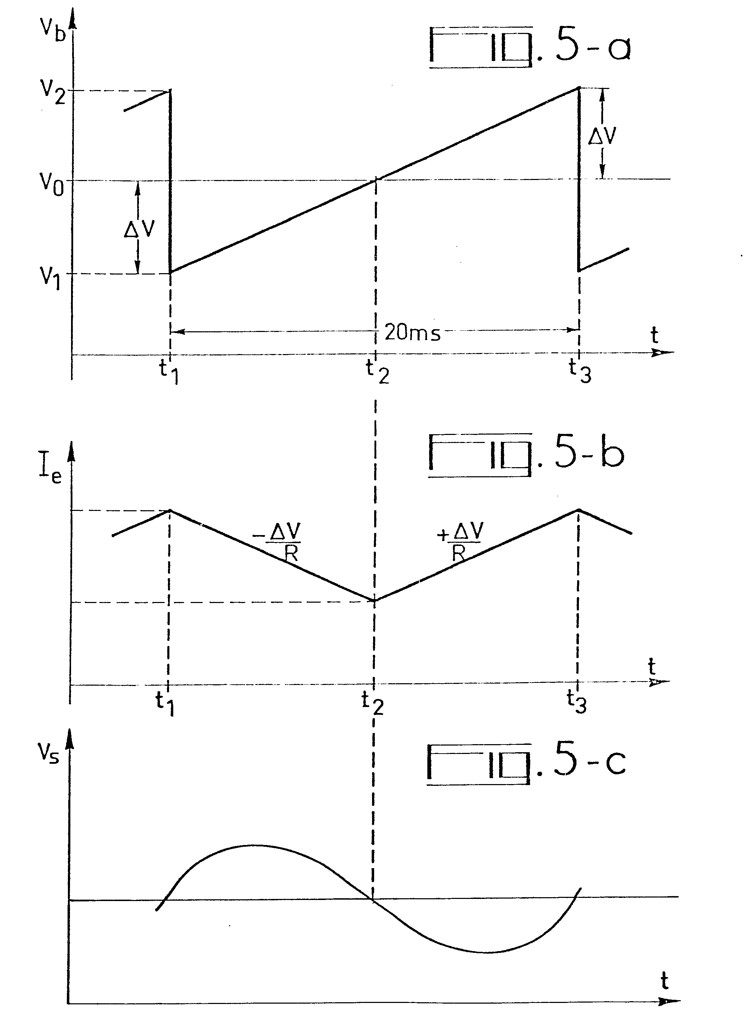

Les diagrammes de la figure 5 illustrent les formes d'onde:
a) à la sortie de l'oscillateur 1;
b) à la sortie du circuit d'inversion de polarité commuté 6;
c) à la sortie du soustracteur 7.

Ces diagrammes permettant, en coopération avec la figure 4, de revenir sur une explication plus détaillée du fonctionnement du circuit.

L'oscillateur 1 est synchronisé par des impulsions $V_a$ de période T=20 ms (pour les normes européennes). Le signal de sortie $V_b$ de l'oscillateur est une tension en dents de scie (figure 5a) de valeur moyenne $V_0$, comprise entre une valeur de démarrage $V_1$ à l'instant $t_1$ et une

valeur maximale $V_2$ à l'instant $t_3$.

La tension de démarrage $V_1$ est choisie comme étant égale à une fraction de la tension d'alimentation $V_{cc}$: par exemple $V_{cc/4}$.

La tension maximale $V_2$ dépend de la constante de temps RC de l'oscillateur. En effet, l'augmentation de tension aux bornes de la capacité de l'oscillateur est égale à:

$$\Delta V = \frac{I}{C} \Delta t.$$

On choisit $I = V_{cc}/R$

$$\Delta V = \frac{V_{cc}}{RC} \Delta t.$$

A la fin de la période, c'est-à-dire pour un balayage vertical normalisé en télévision: $\Delta t = 20 \cdot 10^{-3}$ sec (normes européennes).

$$V_2 = V_1 + \frac{V_{cc} \cdot 20 \cdot 10^{-3}}{RC}.$$

On choisit RC pour que la tension maximale $V_2$ soit égale à $3 V_{cc}/4$ par exemple: ainsi, on connaît avec une bonne précision la tension continue qui correspond à la valeur moyenne $V_0$ du signal, valeur atteinte à l'instant $t_2 = T/2$:

$$v_0 = V_{cc}/2$$

Le circuit d'inversion de polarité commuté 6 est un dispositif qui transforme le signal monotone d'une dent de scie en un signal triangulaire, ou en M, par inversion de la première partie de la dent de scie — comprise entre $t_1$ et $t_2$ — par rapport à la tension moyenne $V_0$. L'oscillogramme de la figure 5b représente le signal triangulaire issu de l'inverseur 6.

La tension de référence $V_{ref}$ appliquée sur une deuxième entrée du circuit 6 est égale à $V_0$, soit $V_{cc}/2$. Inverser une partie de la dent de scie, celle dont la tension est inférieure à la tension moyenne $V_0$, est réalisable parce que la tension $V_0$ est connue avec une bonne précision qui dépend des composants R et C de l'oscillateur.

La figure 6 représente le schéma électrique du circuit inverseur de polarité 6. Il est essentiellement composé de deux montages différentiels constitués par les transistors $T_1$ et $T_2$ d'une part, et $T_3$ et $T_4$ d'autre part. Chacun des deux montages différentiels est réuni à un générateur de courant I, mais est déséquilibré volontairement: en effet, le transistor $T_1$ dans le premier montage différentiel et le transistor $T_4$ dans le second montage différentiel comprennent chacun une résistance $R_4$ connectée entre leur émetteur et la source de courant, cependant que les transistors $T_2$ et $T_3$ ne comprennent pas de résistance d'émetteur. Le signal $V_b$ en dents de scie est appliqué sur les bases des transistors $T_1$ et $T_3$, et la tension de référence $V_{ref}$ est appliquée sur les bases des transistors $T_2$ et $T_4$. Cette tension, prélevée sur un pont diviseur composé par deux résistances $R_5$ égales, alimenté par la tension d'alimentation $V_{cc}$, est égale à $V_{cc}/2$ (ou $V_0$). La tension $V_{cc}$ alimente le circuit par l'intermédiaire des collecteurs des deux transistors $T_2$ et $T_3$. Le signal $I_e$ de sortie du circuit est prélevé en un point commun aux collecteurs des deux transistors $T_1$ et $T_4$.

Pendant la première partie de la dent de scie — voir figure 5a — entre $t_1$ et $t_2$, c'est-à-dire lorsque la tension du signal $V_b$ est inférieure à $V_0$ et tandis que la tension $V_b$ croît de $\Delta V = V_0 - V_1$, les transistors $T_2$ et $T_4$ conduisent, mais le transistor $T_1$ est bloqué et le transistor $T_3$ conduit. A chaque instant, le courant dans le collecteur du transistor $T_4$ pendant cette phase est:

$$I_{T_4} = \frac{V_0 - V_b}{R_4}.$$

C'est le courant de sortie, $I_e$, du circuit inverseur.

Pendant la deuxième partie de la dent de scie, entre $t_2$ et $t_3$, $V_b$ est supérieure à $V_0$ et la tension croît globalement de $\Delta V = V_2 - V_0$ les transistors $T_1$, $T_2$ et $T_3$ conduisent, mais le transistor $T_4$ est bloqué. Le courant dans le collecteur du transistor $T_1$ pendant cette phase est:

$$I_{T_1} = \frac{V_b - V_0}{R_4}.$$

Durant les intervalles de temps $t_1$ $t_2$ et $t_2$ $t_3$, la pente du signal $I_e$ s'inverse: la dent de scie est transformée en un signal de forme triangulaire.

Le bloc fonctionnel 7, sur la figure 4, représente un circuit soustracteur, qui supprime la composante en dent de scie présente dans les courants de sortie $I_1$ et $I_2$ du circuit multiplieur 5, pour ne conserver que l'information de correction en S.

En effectuant la soustraction $I_1 - I_2$, le signal de sortie $V_S$ est un signal de précorrection pur, qui peut alors être additionné à un signal en dents de scie dans un rapport déterminé pour donner la précorrection nécessaire selon le circuit de balayage vertical et le tube image envisagé.

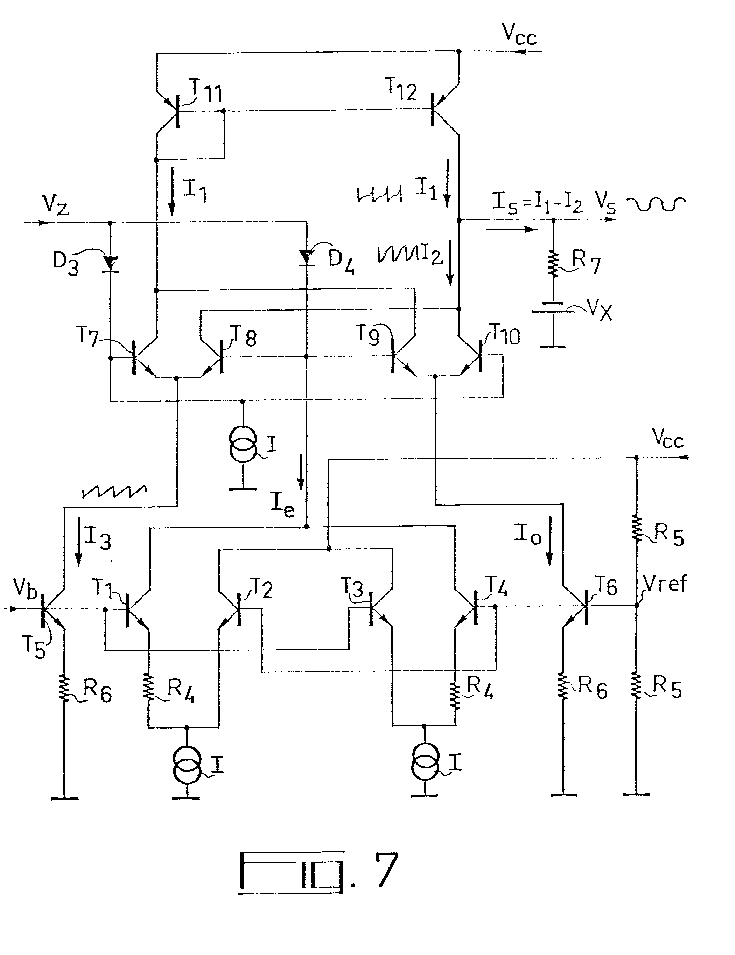

La figure 7 représente le schéma électrique du circuit de précorrection selon l'invention, dans un exemple de réalisation en circuit intégré. L'oscillateur 1 de la figure 4 n'y est pas représenté, et le signal d'entrée est au niveau du signal $V_b$ en dents de scie, issu de l'oscillateur.

L'ensemble des transistors $T_1$ à $T_4$, les résistances $R_4$ et $R_5$ et les deux générateurs de courant associés constituent le circuit 6 d'inversion de polarité commuté, tel que décrit à l'occasion de la figure 6.

Le circuit multiplieur 5 comprend les transistors $T_5$ à $T_{10}$, les diodes $D_3$ et $D_4$, et le générateur de courant associé.

Le circuit soustracteur 7 est constitué par les transistors $T_{11}$ et $T_{12}$.

Le circuit 5 est un circuit symétrique, constitué par deux montages différentiateurs, les transistors $T_7$ et $T_8$ d'une part, les transistors $T_9$ et $T_{10}$

d'autre part. Le premier montage $(T_7 + T_8)$ est réuni par ses émetteurs à un transistor $T_5$, dont la base reçoit le signal en dents de scie $V_b$, et dont l'émetteur est à la masse à travers une résistance $R_6$. De la même façon, le second montage $(T_9 + T_{10})$ est réuni par ses émetteurs à un transistor $T_6$, dont la base reçoit la tension de référence $V_{ref}$. Une source de courant I est réunie aux bases des deux transistors $T_7$ et $T_{10}$, cependant que les bases des transistors $T_8$ et $T_9$ sont réunies entre elles. A partir d'une tension stable $V_z$, deux diodes identiques $D_3$ et $D_4$ polarisent les bases des transistors $T_7$ et $T_{10}$ (pour $D_3$) et des transistors $T_8$ et $T_9$ (pour $D_4$). Le signal $I_e$, issu du circuit d'inversion de polarité, est appliqué au point commun entre les bases des transistors $T_8$ et $T_9$ et la diode $D_4$.

Les collecteurs des transistors $T_7$ et $T_9$ sont réunis au collecteur du transistor $T_{11}$. Les collecteurs des transistors $T_8$ et $T_{10}$ sont réunis au collecteur du transistor $T_{12}$, $T_{11}$ et $T_{12}$ constituant un circuit soustracteur.

Le courant de sortie $I_s$ est prélevé entre les transistors $T_{10}$ et $T_{12}$, et transformé en une tension $V_s$ par l'intermédiaire d'une résistance $R_7$ reliée à une source de tension $V_x$.

La tension en dents de scie $V_b$, appliquée sur la base du transistor $T_5$, est transformée en un courant $I_3$, en dents de scie, de valeur moyenne $I_o$, égale à celle du courant $I_o$ qui traverse le transistor $T_6$, les résistances $R_6$ sur les émetteurs des transistors $T_5$ et $T_6$ étant identiques: en effet, la tension $V_{ref}$ appliquée sur la base du transistor $T_6$ est égale à $V_o$, qui est la valeur moyenne de la tension $V_b$.

Le courant $I_3$ est adressé au premier montage différentiel formé par les transistors $T_7$ et $T_8$, dont les bases sont polarisées, à partir d'une tension de polarisation $V_z$, à travers deux diodes $D_3$ et $D_4$. Or, si le courant de commande dans la diode $D_3$ est constant, celui de la diode $D_4$ est de forme triangulaire, parce que la diode $D_4$ est reliée à la sortie du circuit d'inversion de polarité, dont le signal $I_e$ est de forme triangulaire. Il en résulte que le courant $I_3$ est distribué de façon variable dans $T_7$ et dans $T_8$. Ainsi, les transistors $T_7$ et $T_8$ constituent un montage différentiel commandé par le rapport des courants dans les diodes $D_3$ et $D_4$ ou, ce qui revient au même, par le signal de sortie $I_e$ du circuit d'inversion de polarité.

Le courant constant $I_o$ est adressé au second montage différentiel formé par les transistors $T_9$ et $T_{10}$ de manière à ce que, $I_1$ étant la somme des courants qui traversent les transistors $T_7$ et $T_9$, et $I_2$ étant la somme des courants qui traversent les transistors $T_8$ et $T_{10}$, les composants continues, en forme de dents de scie, des courants $I_1$ et $I_2$ soient identiques.

Les formes d'ondes dans le circuit sont les suivantes:
— le courant $I_3$, sur le collecteur de $T_5$, est une dent de scie, de forme identique à celle du signal $V_b$ issu de l'oscillateur;
— le courant $I_o$, sur le collecteur de $T_6$, est un courant continu, puisque $V_{ref}$ appliquée sur

la base de $T_6$ est une tension continue;
— le courant $I_1$, égal à la somme des courants de collecteur des transistors $T_7$ et $T_9$, est un courant en dents de scie corrigé en S dans un sens;
— le courant $I_2$, égal à la somme des courants de collecteur des transistors $T_8$ et $T_{10}$, est un courant en dents de scie, de même sens que le courant $I_1$, mais corrigé en S dans le sens contraire de la correction exercée sur $I_1$;
— le courant $I_s$, ou la tension $V_s$, est obtenu par soustraction de $I_1 - I_2$; les dents de scie s'annulent et il ne demeure que la correction en S (voir figure 5C).

Le circuit de précorrection en S selon l'invention peut être associé à n'importe quel circuit de balayage vertical dont l'amplificateur de puissance fonctionne avec ou sans condensateur de liaison en classe B ou en classe D.

La figure 8 représente en premier exemple d'utilisation du circuit de précorrection selon l'invention.

Un oscillateur 1, commandé par les impulsions de synchronisation $V_a$, délivre un signal en dents de scie $V_b$ sur deux bornes de sortie. A partir de ces deux bornes de sortie, le signal $V_b$ est adressé à un sommateur 9, d'une part par une voie directe comportant une résistance connectée sur la première borne d'entrée du sommateur 9, d'autre part, par l'intermédiaire d'un circuit de précorrection 8, selon l'invention, et d'une résistance connectée sur la deuxième borne d'entrée du sommateur. Un signal en dents de scie corrigé en S est délivré sur la borne de sortie du sommateur.

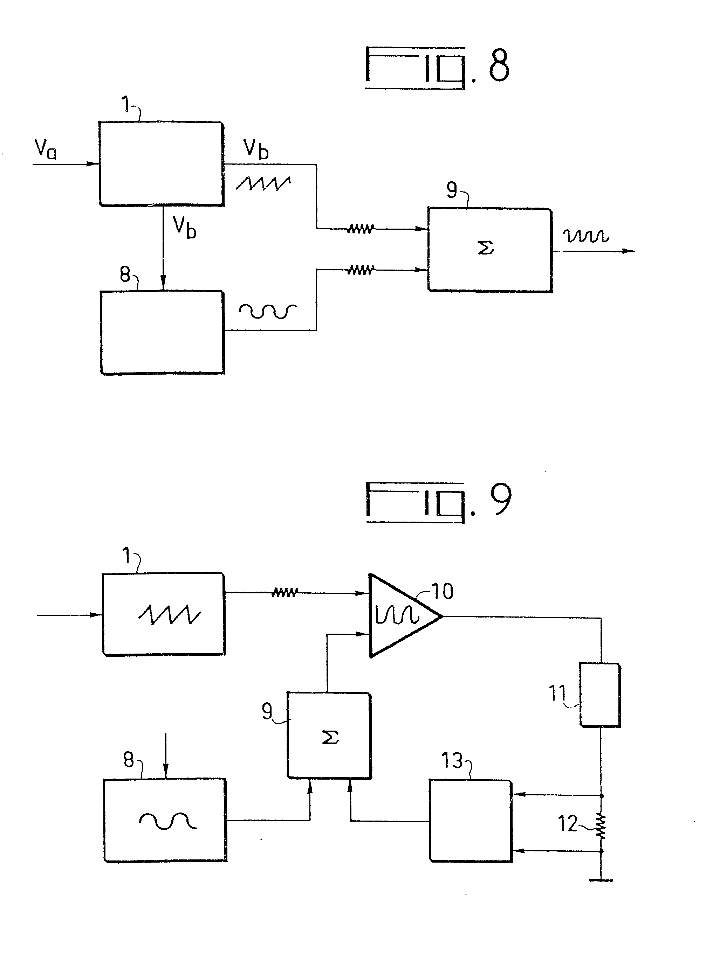

Dans un second exemple de réalisation, illustré par la figure 9, le circuit de précorrection intervient au niveau de la contre-réaction de l'amplificateur de puissance. Selon un schéma classique, un circuit de balayage vertical en télévision comprend au moins un oscillateur 1, dont le signal de sortie en dents de scie est adressé sur une première entrée d'un amplificateur de puissance 10: le courant de sortie de cet amplificateur traverse un déviateur 11 et une résistance de mesure 12, montée en série avec le déviateur. La différence de tension prélevée aux deux bornes de la résistance de mesure 12 est appliquée à un circuit de contre-réaction 13, dont le signal de sortie est rebouclé sur la seconde borne d'entrée de l'amplificateur de puissance 10: ce schéma constitue un circuit classique. Le perfectionnement apporté par l'invention consiste en ce qu'un sommateur 9 est intercalé entre le circuit de contre-réaction 13 et l'amplificateur de puissance 10. Le sommateur 9 reçoit sur une première borne d'entrée le signal de contre-réaction issu du circuit 13 et sur une seconde borne d'entrée le signal de correction en S issu du circuit de précorrection 8, selon l'invention. Le signal de sortie du sommateur 9, qui est en forme de dents de scie corrigée en S, est adressé sur la seconde borne d'entrée de l'amplificateur de puissance 10.

Le circuit de précorrection de l'invention concerne le balayage vertical de tous les tubes-image, dans des applications telles que récepteurs de télévision ou consoles de visualisation, en informatique ou en télétraitement de données.

L'absence de composants non intégrables, mis à part la résistance R et le condensateur C du circuit oscillateur 1, le rend particulièrement apte à l'intégration monolithique sur un cristal semiconducteur, selon la technologie dite des circuits intégrés.

## Revendications

1. Circuit de précorrection du signal de balayage vertical d'un tube de visualisation, le balayage étant piloté par un oscillateur (1) fournissant un signal ($V_b$) en dents de scie, ce circuit de précorrection étant caractérisé en ce qu'il comporte:
— un circuit d'inversion de polarité commuté (6) qui reçoit sur sa borne d'entrée le signal en dents de scie ($V_b$) et restitue sur sa borne de sortie un signal triangulaire ($I_e$), obtenu par inversion de polarité d'une fraction de la dent de scie, par rapport à une tension de référence ($V_{ref}$) comprise entre les deux tensions de crête de la dent de scie;
— un circuit électronique (5) qui reçoit sur sa borne d'entrée le signal en dents de scie ($V_b$) issu de l'oscillateur (1) et sur sa borne de commande le signal triangulaire ($I_e$) issu du circuit d'inversion de polarité (6), ce circuit électronique délivrant sur ses bornes de sortie deux courants ($I_1$ et $I_2$) en dents de scie, de même sens et de même période que le signal en dents de scie d'entrée ($V_b$), l'un des courants étant affecté d'une correction en S dans un sens et l'autre courant étant affecté de la même correction mais de sens opposé;
— un circuit soustracteur (7) qui reçoit sur ses deux bornes d'entrée les deux courants ($I_1$ et $I_2$) issus du circuit électronique (5) et restitue sur sa borne de sortie le signal ($V_S$) de précorrection, par élimination de la composante en dents de scie.

2. Circuit de précorrection selon la revendication 1, caractérisé en ce que le circuit d'inversion de polarité (6) comprend un montage symétrique de deux amplificateurs différentiels:
— le premier amplificateur différentiel comportant un premier transistor ($T_1$) sur la base duquel est appliqué le signal en dents de scie ($V_b$) et dont l'émetteur est chargé par une résistance ($R_4$) et un second transistor ($T_2$) sur la base duquel est appliquée la tension de référence ($V_{ref}$);
— le second amplificateur différential comportant un troisième transistor ($T_3$), sur la base duquel est appliqué le signal en dents de scie ($V_b$) et un quatrième transistor ($T_4$) sur la base duquel est appliquée la tension de référence ($V_{ref}$) et dont l'émetteur est chargé par une résistance ($R_4$), identique à celle qui charge l'émetteur du premier transistor;

le point commun aux deux collecteurs des second et troisième transistors étant connecté à une source d'alimentation ($V_{cc}$), et le signal de sortie ($I_e$) étant pris sur le point commun aux deux collecteurs des premier et quatrième transistors.

3. Circuit de précorrection selon la revendication 1, caractérisé en ce que ledit circuit électronique (5) comprend un montage symétrique de deux amplificateurs différentiels;
— le premier amplificateur différentiel comportant des premier ($T_7$) et second ($T_8$) transistors, dont les bases sont respectivement polarisées par des première ($D_3$) et seconde ($D_4$) diodes et dont les émetteurs reçoivent un courant en dents de scie ($I_3$), la première diode ($D_3$) étant parcourue par un courant constant ($I$);
— le second amplificateur différentiel comportant des troisième ($T_9$) et quatrième ($T_{10}$) transistors dont les bases sont respectivement reliées aux bases desdits second ($T_8$) et premier ($T_7$) transistors et dont les émetteurs reçoivent un courant constant ($I_0$);

les deux amplificateurs différentiels étant commandés, sur le point commun à la seconde diode ($D_4$) et aux bases des second et troisième transistors ($T_8$ et $T_9$) par le signal triangulaire ($I_e$) issu du circuit d'inversion de polarité, les collecteurs des premier ($T_7$) troisième ($T_9$) transistors étant reliés et délivrant le premier signal en dents de scie ($I_1$) affecté d'une correction en S dans un premier sens, et les collecteurs des second ($T_8$) et quatrième ($T_{10}$) transistors étant reliés et délivrant le second signal en dents de scie ($I_2$) affecté d'une correction en S dans un second sens, inverse de la précédente.

4. Circuit de précorrection selon la revendication 1, caractérisé en ce qu'il est totalement intégré sur un cristal semiconducteur.

5. Récepteur de télévision, caractérisé en ce qu'il comporte un circuit de balayage vertical dont la précorrection est assurée par un circuit de précorrection selon l'une quelconque des revendications 1 à 4.

## Patentansprüche

1. Schaltung zur Vorkorrektur des Vertikalabtastsignals einer Bildröhre, wobei die Abtastung durch einen ein sägezahnförmiges Signal ($V_b$) erzeugenden Oszillator (1) gesteuert wird und diese Vorkorrekturschaltung dadurch gekennzeichnet ist, daß sie umfaßt:
— einen geschalteten Polumschaltkreis (6), an dessen Eingangsklemme das sägezahnförmige Signal ($V_b$) angelegt ist und der an der an seiner Ausgangsklemme ein durch die Umpolung eines Teils des Sägezahns erziel-

tes, dreieckförmiges Signal ($I_e$) abgibt, in bezug auf eine zwischen den beiden Spitzenspannungen des Sägezahns liegende Bezugsspannung ($V_{ref}$);

— einen elektronischen Stromkreis (5), an dessen Eingangsklemme das vom Oszillator (1) erzeugte sägezahnförmige Signal ($V_b$) angelegt ist, und an dessen Steuerklemme das vom Polumschaltkreis (6) abgegebene dreieckförmige Signal ($I_e$) angelegt ist, wobei dieser elektronische Stromkreis an seinen Ausgangsklemmen zwei sägezahnförmige Ströme ($I_1$ und $I_2$) abgibt, deren Richtung und Periode denjenigen des sägezahnförmigen Eingangssignals ($V_b$) gleich sind und wobei einer dieser Ströme zur »S-Korrektur« in einer Richtung dient, während der andere Strom zur gleichen Korrektur in entgegengesetzter Richtung dient;

— einen Subtraktionskreis (7), an dessen beide Eingangsklemmen die beiden vom elektronischen Stromkreis (5) gelieferten Ströme ($I_1$ und $I_2$) angelegt sind, und der an seiner Ausgangsklemme durch Unterdrückung der sägezahnförmigen Komponente das Vorkorrektursignal ($V_S$) abgibt.

2. Vorkorrekturschaltung nach Anspruch 1, dadurch gekennzeichnet, daß der Polumschaltkreis (6) eine zwei Differentialverstärker umfassende, symmetrische Schaltung aufweist, wobei:

— der erste Differentialverstärker einen ersten Transistor ($T_1$) besitzt, an dessen Basis das sägezahnförmige Signal ($V_b$) angelegt ist und dessen Emitter über einen Widerstand ($R_4$) und einen zweiten Transistor ($T_2$) beaufschlagt wird, an dessen Basis die Bezugsspannung ($V_{ref}$) angelegt ist;

— der zweite Differentialverstärker einen dritten Transistor ($T_3$) aufweist, an dessen Basis das sägezahnförmige Signal ($V_b$) angelegt ist, sowie einen vierten Transistor ($T_4$), an dessen Basis die Bezugsspannung ($V_{ref}$) angelegt ist und dessen Emitter über einen dem den Emitter des ersten Transistors beaufschlagenden Widerstand gleichen Widerstand ($R_4$) beaufschlagt wird; während der gemeinsame Punkt der beiden Kollektoren des zweiten und dritten Transistors an eine Speisequelle ($V_{cc}$) angeschlossen ist und das Ausgangssignal ($I_e$) am gemeinsamen Punkt der beiden Kollektoren des ersten und vierten Transistors abgenommen wird.

3. Vorkorrekturschaltung nach Anspruch 1, dadurch gekennzeichnet, daß der elektronische Stromkreis (5) eine zwei Differentialverstärker umfassende, symmetrische Schaltung aufweist, wobei:

— der erste Differentialverstärker einen ersten Transistor ($T_7$) und einen zweiten Transistor ($T_8$) besitzt, deren Basiselektroden durch eine erste bzw. zweite Diode ($D_3$ bzw. $D_4$) polarisiert werden und deren Emitter einen sägezahnförmigen Strom ($I_3$) empfangen, wobei die erste Diode ($D_3$) von einem konstanten Strom ($I$) durchflossen wird;

— der zweite Differentialverstärker einen dritten Transistor ($T_9$) und einen vierten Transistor ($T_{10}$) besitzt, deren Basiselektroden an je eine der Basiselektroden des zweiten bzw. des ersten Transistors ($T_8$ bzw. $T_7$) angeschlossen sind und deren Emitter einen konstanten Strom ($I_o$) empfangen;

— die beiden Differentialverstärker am gemeinsamen Punkt der zweiten Diode ($D_4$) und der Basiselektroden des zweiten und des dritten Transistors ($T_8$ und $T_9$) durch das vom Polumschaltkreis abgegebene dreieckförmige Signal ($I_e$) gesteuert werden, während die Kollektoren des ersten und des dritten Transistors ($T_7$ bzw. $T_9$) miteinander verbunden sind und das erste, in einer ersten Richtung »S-korrigierte« sägezahnförmige Signal ($I_1$) abgeben und die Kollektoren des zweiten und des vierten Transistors ($T_8$ bzw. $T_{10}$) miteinander verbunden sind und das zweite, in einer der ersten Richtung entgegengesetzten zweiten Richtung »S-korrigierte« sägezahnförmige Signal ($I_2$) abgeben.

4. Vorkorrekturschaltung nach Anspruch 1, dadurch gekennzeichnet, daß sie gänzlich auf einem Halbleiterkristall angeordnet ist.

5. Fernsehempfänger, dadurch gekennzeichnet, daß er einen Vertikalabtaststromkreis aufweist, dessen Vorkorrektur vermittels einer Vorkorrekturschaltung nach einem der Ansprüche 1 bis 4 erfolgt.

**Claims**

1. Precorrection circuit of the vertical sweeping signal of a visualization tube, the sweeping being piloted by an oscillator (1) supplying a saw-tooth signal ($V_b$), this precorrection circuit being characterized in that it comprises:

— a switch on polarity reversal circuit (6) that receives on its input terminal the saw-tooth signal ($V_b$) and returns on its exit terminal a triangular signal ($I_e$), obtained by polarity reversal of a fraction of the saw-tooth, with respect to a reference voltage ($V_{ref}$) comprised between the two peak voltages of the saw-tooth;

— an electronic circuit (5) that receives on its input terminal the saw-tooth signal ($V_b$) issuing from the oscillator (1) and on its control terminal the triangular signal ($I_e$) issuing from the polarity reversal circuit (6), this electronic circuit delivering on its output terminals two saw-tooth currents ($I_1$ and $I_2$), in the same direction and of the same period as the input saw-tooth signal ($V_b$), one of the currents being affected by an S correction in one direction and the other current being affected by the same correction but in the opposite direction;
— a subtracting circuit (7) that receives on its two input terminals the two currents ($I_1$ and $I_2$) issuing from the electronic circuit (5) and returning on its input terminal the precorrection signal ($V_S$), by elimination of the saw-tooth component.

2. Precorrection circuit according to claim 1, characterized in that the polarity reversal circuit (6) comprises a symmetrical mounting of two differential amplifiers;
— the first differential amplifier comprising a first transistor ($T_1$) on the base of which is applied the saw-tooth signal ($V_b$) and the emitter of which is charged by a resistance ($R_4$) and a second transistor ($T_2$) on the base of which is applied the reference voltage ($V_{ref}$);
— the second differential amplifier comprising a third transistor ($T_3$), on the base of which is applied the saw-tooth signal ($V_b$) and a fourth transistor ($T_4$) on the base of which is applied the reference voltage ($V_{ref}$) and of which the emitter is charged by a resistance, ($R_4$), identical to that which charges the emitter of the first transistor;
the common point of the two collectors of the second and third transistors being connected to a feed source (Vcc) and the output signal ($I_e$) being taken on the common point of the two collectors of the first and fourth transistors.

3. Precorrection circuit according to claim 1, characterized in that the said electronic circuit (5) comprises a symmetrical mounting of two differential amplifiers:
— the first differential amplifier comprising first ($T_7$) and second ($T_8$) transistors the bases of which are respectively polarized by the first ($D_3$) and second ($D_4$) diodes and of which the emitters receive a saw-tooth current ($I_3$), the first diode ($D_3$) being through-crossed by a constant current (I);
— the second differential amplifier comprising third ($T_9$) and fourth ($T_{10}$) transistors the bases of which are respectively connected to the bases of the second ($T_8$) and first ($T_7$) transistors and of which the emitters receive a constant current ($I_o$);
the two differential amplifiers being controlled, on the common point at the second diode ($D_4$) and to the second and third transistors ($T_8$ and $T_9$) by the triangular signal ($I_e$) issuing from the polarity reversal circuit, the collectors of the first ($T_7$) and third transistors ($T_9$) being connected and delivering the first saw-tooth signal ($I_1$) affected by an S connection in a first direction, and the collectors of the second ($T_8$) and fourth ($T_{10}$) transistors being connected and delivering the second saw-tooth signal ($I_2$) affected by an S correction in a second direction, opposite to the previous direction,

4. Precorrection circuit according to claim 1, characterized in that it is totally integrated on a semi-conductor crystal.

5. Television receiver, characterized in that it comprises a vertical sweeping circuit the precorrection of which is ensured by a precorrection circuit according to one of claims 1 to 4.

FIG. 1

FIG. 2-a

FIG. 2-b

FIG. 2-c

FIG. 2-d

Fig. 3

Fig. 4

Fig. 6

FIG. 5-a

FIG. 5-b

FIG. 5-c

FIG. 7

0 024 223

# FIG. 8

# FIG. 9